# EUROPÄISCHE PATENTSCHRIFT

(11) **EP 2 616 411 B1**
(45) Veröffentlichungstag und Bekanntmachung des Hinweises auf die Patenterteilung: **25.04.2018**
(21) Anmeldenummer: 11760757.2
(22) Anmeldetag: 16.09.2011
(51) Int. Cl.: C04B 35/475, H01L 41/43, C04B 35/49, C04B 35/638, C04B 35/626, H01L 41/187, C04B 35/462

(54) **KERAMISCHER WERKSTOFF AUF DER BASIS VON DEM PEROWSKIT BI0,5NA0,5TIO3, PIEZOELEKTRISCHER AKTOR ENTHALTEND DEN KERAMISCHEN WERKSTOFF UND VERFAHREN ZUR HERSTELLUNG DES KERAMISCHEN WERKSTOFFS**
CERAMIC MATERIAL BASED ON THE PEROVSKITE BI0,5NA0,5TIO3, PIEZOELECTRIC ACTUATOR CONTAINING THE CERAMIC MATERIAL AND PROCESS FOR PRODUCING THE CERAMIC MATERIAL
MATÉRIAU CÉRAMIQUE À BASE DE PÉROVSKITE BI0,5NA0,5TIO3, ACTIONNEUR PIÉZOÉLECTRIQUE CONTENANT CE MATÉRIAU CÉRAMIQUE ET PROCÉDÉ DE PRODUCTION DE CE MATÉRIAU CÉRAMIQUE

(30) Priorität: 16.09.2010 DE 102010045597
(43) Veröffentlichungstag der Anmeldung: 24.07.2013
(73) Patentinhaber: Epcos AG, 81671 München (DE)
(72) Erfinder: WANG, Yongli, A-8523 Frauental (AT); HOFFMANN, Christian, 83075 Bad Feilnbach (DE)
(74) Vertreter: Epping - Hermann - Fischer
(86) Internationale Anmeldenummer: PCT/EP2011/066138
(87) Internationale Veröffentlichungsnummer: WO 2012/035151

(56) Entgegenhaltungen:
- CN-A- 1 541 976
- DE-A1-102009 029 511
- JP-A- 2002 321 976
- US-A1- 2002 036 282
- HERABUT A ET AL: "Effects of substitution in A- and B-site cations of Bi0.5Na0.5TiO3", FERROELECTRICS, 1996. ISAF '96., PROCEEDINGS OF THE TENTH IEEE INTERNA TIONAL SYMPOSIUM ON APPLICATIONS OF EAST BRUNSWICK, NJ, USA 18-21 AUG. 1996, NEW YORK, NY, USA,IEEE, US, Bd. 2, 18. August 1996 (1996-08-18), Seiten 775-778, XP010228000, DOI: 10.1109/ISAF.1996.598139 ISBN: 978-0-7803-3355-0
- DANWITTAYAKUL S ET AL: "Influence of isovalent and aliovalent substitutions at Ti site on bismuth sodium titanate-based compositions on piezoelectric properties", CERAMICS INTERNATIONAL, ELSEVIER, AMSTERDAM, NL, Bd. 34, Nr. 4, 1. Mai 2008 (2008-05-01), Seiten 765-768, XP022623303, ISSN: 0272-8842, DOI: 10.1016/J.CERAMINT.2007.09.097 [gefunden am 2008-04-24]
- KANTHA P ET AL: "Phase formation and electrical properties of BNLT-BZT lead-free piezoelectric ceramic system", CURRENT APPLIED PHYSICS, NORTH-HOLLAND, AMSTERDAM, NL, vol. 9, no. 2, 1 March 2009 (2009-03-01), pages 460-466, XP025613044, ISSN: 1567-1739, DOI: 10.1016/J.CAP.2008.04.004 [retrieved on 2008-04-15]

## Beschreibung

Es wird ein keramischer Werkstoff, ein piezoelektrischer Aktor mit dem keramischen Werkstoff und ein Verfahren zur Herstellung des keramischen Werkstoffs bereitgestellt.

In piezoelektrischen Aktoren werden häufig Bleizirkonattitanate (PZT) als keramische Materialien verwendet.

JP 2002 321976 A betrifft bleifreie Piezoaktoren, die mit Lanthanoiden dotiert sind, und offenbart: 0,86(Na_{0,5}Bi_{0,5})_{0,99}TiO₃ + 0,12(K_{0,5}Bi_{0,5})_{0,99}TiO₃ + 0,02Ba_{0,99}TiO₃, wobei 0,5 Gew% an La hinzugefügt wird. Es erwähnt aber weder eine Hf- noch eine Zr-Dotierung.
US 2002 036282 A1 betrifft ein elektromechanisch aktives Material mit einer Perowskit-Zusammensetzung der allgemeinen Formel (Na_{1/2}Bi_{1/2})₁₋ₓMₓ(Ti_{1-y}M'_{y})O_{3±z}.
Der Artikel von DANWITTAYAKUL S ET AL: "Influence of isovalent and aliovalent substitutions at Ti site on bismuth sodium titanate-based compositions on piezoelectric properties", (CERAMICS INTERNATIONAL, Bd. 34, Nr. 4, Mai 2008, Seiten 765-768) beschreibt bleifreie, piezoelektrische Werkstoffe mit hoher Curietemperatur T_{c} und offenbart ein mit La modifiziertes Bismut-Natrium Titanat, das 0,5 bis 2,5 at% Zr⁴⁺ am Ti-Gitterplatz inkorporiert. Die Depolarisationstemperatur T_{d} wird jedoch nicht erwähnt.

Aufgabe zumindest einer Ausführungsform der Erfindung ist es, einen verbesserten keramischen Werkstoff bereitzustellen, der bleifrei ist und verbesserte elektrische Eigenschaften aufweist. Diese Aufgabe wird durch einen keramischen Werkstoff gemäß Anspruch 1 gelöst.

Aufgabe zumindest einer weiteren Ausführungsform ist die Bereitstellung eines piezoelektrischen Aktors mit diesem keramischen Werkstoff und ein Verfahren zur Herstellung des keramischen Werkstoffs. Diese Aufgaben werden gemäß dem piezoelektrischen Aktor nach Anspruch 8 und gemäß einem Verfahren nach Anspruch 9 gelöst.

Weitere Ausführungsformen des keramischen Werkstoffs und des Verfahrens zur Herstellung des keramischen Werkstoffs sind Gegenstand abhängiger Ansprüche.

Es wird ein keramischer Werkstoff angegeben, der die allgemeine Formel (BiₓNa_{y}M¹_{z}LᵤM²ᵥV_{w})(Ti₁₋ₛZₛ)O₃ aufweist. Dabei gilt: x + y + z + u + v + w = 1, 3x + y + z + 3u + 2v = 2 und x, y, z, u sind größer als 0, v ist größer oder gleich 0, insbesondere ist v größer als 0. Weiterhin gilt, dass M¹ zumindest ein Element der ersten Hauptgruppe des Periodensystems, das monovalent sein kann, und M² zumindest ein Element der zweiten Hauptgruppe des Periodensystems, das bivalent sein kann, umfassen. L umfasst zumindest ein Element der Lanthanoide, das trivalent sein kann. V steht für eine Leerstelle in dem Gitter des keramischen Werkstoffs und Z ist ausgewählt aus Zr, Hf und Kombinationen davon.

Es wird also ein keramischer Werkstoff auf der Basis von der Perowskitkeramik Bi_{0,5}Na_{0,5}TiO₃ bereitgestellt, die durch ein oder mehrere Elemente modifiziert ist. Die Perowskitkeramik Bi_{0,5}Na_{0,5}TiO₃, die die allgemeine Struktur ABO₃ aufweist, ist in dem keramischen Werkstoff die Hauptkomponente und bildet das Gastgitter. In dieses Gitter sind die Substituenten M¹, M², L und optional Z und Leerstellen V eingebaut.

Die A-Positionen in dem Perowskitgitter können somit teilweise mit den Elementen M¹, M² oder L besetzt sein, beziehungsweise Leerstellen V aufweisen, auf B-Positionen können teilweise die Elemente Z vorhanden sein.

Gemäß einer Ausführungsform gilt für den keramischen Werkstoff (BiₓNa_{y}M¹_{z}LᵤM²ᵥV_{w})(Ti₁₋ₛZₛ)O₃: 0,005 ≤ z ≤ 0,25, 0,005 ≤ v ≤ 0,25, 0,001 ≤ u ≤ 0,02, 0 ≤ w ≤ 0,02 und 0 < s ≤ 0,2.

M¹ ist ausgewählt aus einer Gruppe, die Li und K umfasst, M² ist aus einer Gruppe ausgewählt, die Ca, Sr und Ba umfasst. Somit umfasst M¹ ein Alkalimetall und M² ein Erdalkalimetall. L kann aus einer Gruppe ausgewählt sein, die La, Ce, Pr, Nd, Pm, Sn, Bu, Gd, Tb, Dy, Ho, Br, Tm und Yb umfasst.

Gemäß einer weiteren Ausführungsform ist der keramische Werkstoff ein bleifreier keramischer Werkstoff. Damit wird ein umweltfreundlicher und gesundheitlich unbedenklicher keramischer Werkstoff bereitgestellt.

Es wird ein keramischer Werkstoff beschrieben, der die Formel Bi_{0,49}Na_{0,335}k_{0,125}Li_{0,04}Nd_{0,01}TiO₃ aufweist.

Ein keramischer Werkstoff gemäß der obigen Formel und den obigen Ausführungsformen weist eine hohe Dehnung auf, die durch einen nicht-piezoelektrischen Effekt bedingt wird, nämlich durch eine feldinduzierte Phasenumwandlung.

Durch die Substituenten und/oder Leerstellen in dem Perowskitgitter wird die nicht-polare Phase des keramischen Werkstoffs in einem breiten Temperaturbereich stabilisiert. Der keramische Werkstoff weist also bezüglich der normalerweise reversiblen Umwandlung zwischen polarer und nicht-polarer Phase eine Stabilität gegenüber Temperaturänderungen in einem breiten Temperaturbereich auf. In diesem breiten Temperaturbereich ist die nicht-polare Phase also nicht durch eine Temperaturveränderung umwandelbar in eine polare Phase. Eine solche Umwandlung zieht normalerweise eine Hysterese und einen hohen dielektrischen Verlust nach sich, was zu einer verminderten Effizienz bei der Energieübertragung führt.

Der keramische Werkstoff kann eine Depolarisationstemperatur T_{d} < 20°C und eine Curietemperatur T_{c} > 150° aufweisen. Die Curietemperatur T_{c} kann vorzugsweise größer als 200°C, insbesondere > 300°C sein. Die Depolarisationstemperatur kann insbesondere < 0°C sein. Durch die spezielle Zusammensetzung des keramischen Werkstoffs kann also die Depolarisationstemperatur weit unter Raumtemperatur eingestellt werden und die Curietemperatur zu hohen Temperaturen, vorzugsweise mehr als 300°C, verschoben werden. Beide kritischen Temperaturen sind somit weit außerhalb des Temperaturbereichs der für praktische Anwendungen interessant ist, beispielsweise der Bereich zwischen 20°C und 150°C.

Somit ist die elektromechanische Antwort auf ein angelegtes elektrisches Feld des keramischen Werkstoffs nicht oder nur schwach von der Temperatur abhängig, was auch dadurch bedingt ist, dass durch die Substituenten und/oder Leerstellen zu einer Zufälligkeit in dem Gitter führen und dadurch diffuse Phasenübergänge auftreten, was wiederum Energieverluste verringern kann.

Kationenleerstellen und/oder Kationen unterschiedlicher Wertigkeit, die in ein ferroelektrisches Gitter eingeführt werden, erzeugen eine Zufälligkeit des Feldes und/oder der Bindungen durch die regellose Verteilung der Kationen mit unterschiedlichen Ladungen. Diese Zufälligkeit kann die ferroelektrische Ordnung über weite Bereiche unterdrücken, so dass ein diffuser Phasenübergang resultiert. Ein diffuser Phasenübergang findet nicht abrupt bei einer bestimmten Temperatur oder einem bestimmten elektrischen Feld statt, sondern nach und nach in einem Temperatur- oder elektrischen Feldbereich. Damit nimmt die Temperaturabhängigkeit der Eigenschaften ab.

Gleichzeitig wird die dielektrische Hysterese weitgehend unterdrückt sowie die Werte des dielektrischen Verlusts weitgehend niedrig gehalten.

Die Phasenumwandlung vom nicht-polaren zu dem polaren Zustand kann durch Anlegen einer Feldstärke beispielsweise mit einem Wert, der aus dem Bereich zwischen 1 und 6 KV/mm ausgewählt ist, erreicht werden.

In einem Temperaturbereich von 20°C bis 150°C, vorzugsweise von 20°C bis 200°C, besonders bevorzugt von 0°C bis 280°C, kann der dielektrische Verlustfaktor des keramischen Werkstoffs weniger als 0,5, insbesondere weniger als 0,45 sein. Die Dehnung des keramischen Werkstoffs kann in dem Temperaturbereich von 20°C bis 150°C, vorzugsweise von 20°C bis 200°C, insbesondere von 0°C bis 280°C, einen Wert, der aus dem Bereich 0,1% bis 0,3% ausgewählt ist, beispielsweise den Wert 0,2% aufweisen. In dem gleichen Temperaturbereich kann der keramische Werkstoff bei Anlegen eines elektrischen Feldes eine Temperaturabhängigkeit von weniger als 30%, beispielsweise von weniger als 20% aufweisen.

Die kritischen Temperaturen des keramischen Werkstoffs können durch die Substituenten und/oder Leerstellen eingestellt werden. Die Curietemperatur T_{c} kann beispielsweise dadurch erhöht werden, dass Bi und/oder Na in dem keramischen Werkstoff durch Kationen mit kleinerem ionischen Radius, beispielsweise Ca, Li oder Lanthanoide, ersetzt wird. Dagegen kann die Curietemperatur T_{c} erniedrigt werden, wenn Kationen mit größerem Radius, beispielsweise Ba, Sr und K, eingesetzt werden.

Um die Depolarisationstemperatur T_{d} zu beeinflussen, können ebenfalls die Substituenten in dem keramischen Werkstoff herangezogen werden. Außer Li und K haben alle Substituenten einen negativen Einfluss auf die rhomboedrische Phase, das heißt, eine abnehmende Abhängigkeit der Depolarisationstemperatur von dem Gehalt der Substituenten.

Ba und K stabilisieren die tetragonale ferroelektrische Phase über der morphotropen Phasengrenze (MPB = morphotropic phase boundary) und führen somit zu einem höheren T_{d}, wenn sie in höherer Konzentration vorhanden sind. Große Substituenten auf der B-Position des keramischen Werkstoffes, nämlich Zr und Hf, sowie Leerstellen auf der A-Position können T_{d} erniedrigen und den Temperaturbereich, in dem die nicht-polare Phase stabilisiert ist, verbreitern.
Somit können also die entsprechenden Konzentrationen der Substituenten in dem keramischen Werkstoff so eingestellt werden, dass die kritischen Temperaturen T_{d} und T_{c} außerhalb des Temperaturbereichs, der für praktische Anwendungen des keramischen Werkstoffs relevant ist, liegen.
Es wird also ein keramischer Werkstoff bereitgestellt, der eine kontrollierbare Dehnung aufgrund einer Phasenumwandlung aufweist. Es können hohe Dehnungen von bis zu 0,3% nach Anregung mittels eines elektrischen Feldes entstehen. Die elektromechanische Antwort auf eine Anregung ist nicht oder nur geringfügig temperaturabhängig, was zu einer hohen Energieeffizienz des keramischen Werkstoffs führt.
Bei einem keramischen Werkstoff mit den oben genannten Eigenschaften ist es weiterhin nicht notwendig, bei seiner Herstellung einen Polarisationsprozess durchzuführen, bevor der Werkstoff für die gewünschte Anwendung verwendet werden kann, da die Dehnung des Werkstoffs durch einen reversiblen Feldinduzierten Übergang von einer nicht-polaren Phase zu einer ferroelektrischen Phase bedingt ist und somit nicht erst Piezoelektrizität durch einen Polungsprozess erzeugt werden muss. Somit ist die Dehnung des Werkstoffs auch unabhängig von der Polarität des elektrischen Feldes. Damit wird der Herstellungsprozess des keramischen Werkstoffs vereinfacht und somit die Produktionskosten gesenkt und produktionsbezogene Fehler vermindert.
Der keramische Werkstoff ist weiterhin bezüglich seiner Polarität uneingeschränkt anwendbar. Beispielsweise kann er durch unpolare oder dipolare Spannung oder eine Mischung beider Spannungsarten angeregt werden. Der Werkstoff weist also eine hohe Flexibilität in seiner Anwendung auf.
Es wird weiterhin ein piezoelektrischer Aktor angegeben, der einen keramischen Werkstoff gemäß den obigen Ausführungen enthält. Ein solcher piezoelektrischer Aktor weist also eine verbesserte Energieeffizienz bei gleichzeitig geringeren Herstellungskosten auf.
Es wird weiterhin ein Verfahren zur Herstellung eines keramischen Werkstoffs gemäß den obigen Ausführungen angegeben. Das Verfahren weist die Verfahrensschritte A) Mischen und Mahlen von pulverförmigen Ausgangsstoffen im stöchiometrischen Verhältnis, B) Trocknen und Kalzinieren der Mischung, C) Mahlen der Mischung zu einem keramischen Pulver und D) Entbindern und Sintern des keramischen Pulvers zu dem keramischen Werkstoff auf. Die Herstellung des keramischen Werkstoffs kann unter normalen Druck und bei gemäßigten Temperaturen erfolgen. Dies führt zu einer weiteren Senkung der Produktionskosten.
Als Ausgangsstoffe können im Verfahrensschritt A) beispielsweise Oxide und/oder Carbonate von M¹, M², L und Z ausgewählt werden, beispielsweise können Bi₂O₃, Nd₂O₃, Na₂CO₃, Li₂CO₃ und TiO₂ ausgewählt werden. Im Verfahrensschritt B) kann die Mischung bei 60°C getrocknet und bei 750 bis 950 °C, insbesondere bei 800°C kalziniert werden. Weiterhin kann im Verfahrensschritt D) bei 450°C entbindert und bei 1000 bis 1150°C, insbesondere bei 1000 bis 1100°C, gesintert werden.
Anhand der Figuren und der Ausführungsbeispiele sollen einige Aspekte der Erfindung noch näher erläutert werden.
- Figur 1a: graphische Darstellung der Polarisation in Abhängigkeit des elektrischen Feldes einer Ausführungsform des keramischen Werkstoffs,
- Figur 1b: graphische Darstellung der Dehnung in Abhängigkeit des elektrischen Feldes einer Ausführungsform des keramischen Werkstoffs,
- Figur 2a: graphische Darstellung der Temperaturabhängigkeit der Dehnung einer Ausführungsform des keramischen Werkstoffs,
- Figur 2b: graphische Darstellung der Temperaturabhängigkeit des dielektrischen Verlustfaktors einer Ausführungsform des keramischen Werkstoffs,
- Figur 3a: graphische Darstellung des Einflusses von Substituenten auf die Curie-Temperatur des keramischen Werkstoffs,
- Figur 3b: graphische Darstellung des Einflusses von Substituenten auf die Depolarisationstemperatur des keramischen Werkstoffs.

Es wird ein Beispiel des Verfahrens zur Herstellung des keramischen Werkstoffs mit der Formel Bi_{0,49}Nd_{0,01}Na_{0,335}k_{0,125}Li_{0,04}TiO₃ angegeben.

Die pulverförmigen Ausgangsstoffe Bi₂O₃, Nd₂O₃, Na₂CO₃, K₂CO₃, Li₂CO₃ und TiO₂ werden eingewogen, sodass sie die Stöchiometrie der allgemeinen Perowskitformel ABO₃ erfüllen. Die pulverförmigen Ausgangsstoffe weisen eine Reinheit von ≥ 99,8% auf.
Nach dem Mischen der Ausgangsstoffe werden sie in einer Kugelmühle mit ZrO₂-Kugeln, die mittels Yttrium stabilisiert sind, gemahlen, wobei dehydriertes Ethanol als Medium zugesetzt wird. Diese Mischung wird bei 60°C im Ofen getrocknet. Das getrocknete Pulver wird gesiebt und bei 800°C für vier Stunden kalziniert, sodass sich eine homogene Perowskitstruktur bildet. Das kalzinierte Pulver wird nochmals gemahlen, um die Partikelgröße zu verfeinern. Das erhaltene keramische Pulver wird getrocknet und mit einem Polyvinylbutyral(PVB)-Binder versetzt und granuliert. Anschließend wird es zu einem Pressling von 15,6 mm Durchmesser und 1,5 mm Dicke gepresst. Die grünen Presslinge werden bei 450°C für zwei Stunden entbindert und anschließend bei Temperaturen von 1000 bis 1100°C für ein bis zwei Stunden gesintert.
Die beiden sich gegenüberliegenden Oberflächen der Presslinge werden mit einer Silberpaste beschichtet, um Kondensatoren enthaltend den keramischen Werkstoff und Silberelektroden zu erhalten. Die dielektrischen Eigenschaften werden mit einer LCR-Brücke als Funktion der Temperatur T und Frequenz v gemessen. Die Dehnung S des keramischen Werkstoffs wird als Funktion des elektrischen Feldes E und der Temperatur T mit einem aixACCT-piezoelektrischen Auswertungssystem (aixACCT systems GmbH)) ermittelt. Eine dreieckige Wellenform und eine niedrige Frequenz von 0,1 Hz werden als Signal verwendet. Die Amplitude des Feldes E beträgt 4,7 kV/mm.

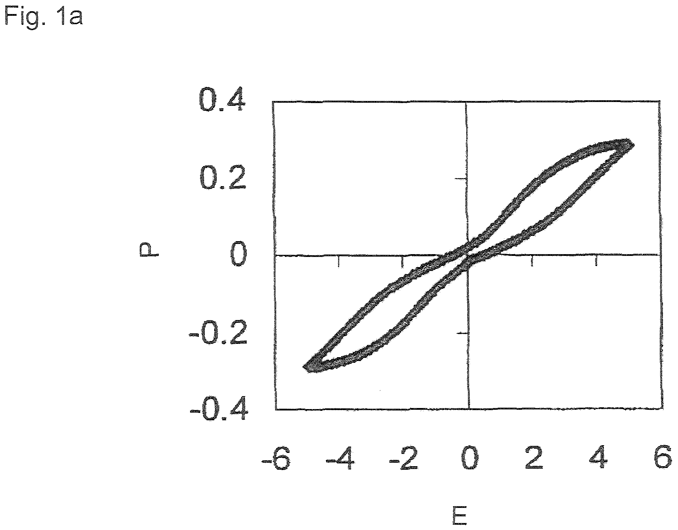

Figur 1a zeigt die graphische Darstellung der Polarisation P in Abhängigkeit des elektrischen Feldes E des keramischen Werkstoffs bei Raumtemperatur. Die y-Achse ist die Polarisation P in C/m², die x-Achse gibt das elektrische Feld E kV/mm an.

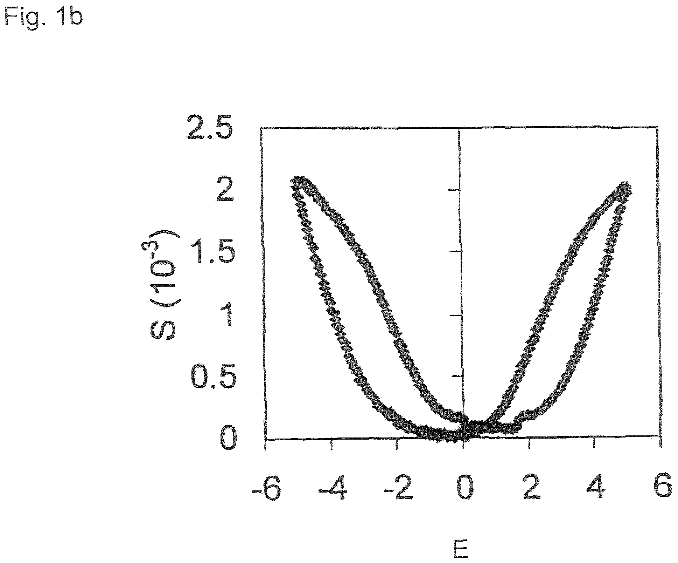

Figur 1b zeigt die graphische Darstellung der Dehnung S, die gegen das elektrische Feld E in kV/mm aufgetragen ist.
Die Dehnung S des keramischen Werkstoffs beträgt 0,2% bei einem Feld von 4,7 kV/mm². Die feldinduzierte Phasenumwandlung findet über einen breiten Bereich, etwa zwischen 2 kV/mm und 5 kV/mm statt, was eine diffuse Phasenumwandlung andeutet.
Aus der P-E-Kurve der Figur 1a kann der dielektrische Verlustfaktor berechnet werden, der einen Wert von etwa 43% aufweist. Dieser Wert ist niedriger als in bislang bekannten bleifreien Keramiken. Ein niedriger dielektrischer Verlustfaktor ist nötig, um eine hohe Effizienz im elektromechanischen Kopplungsverhalten zu erreichen.

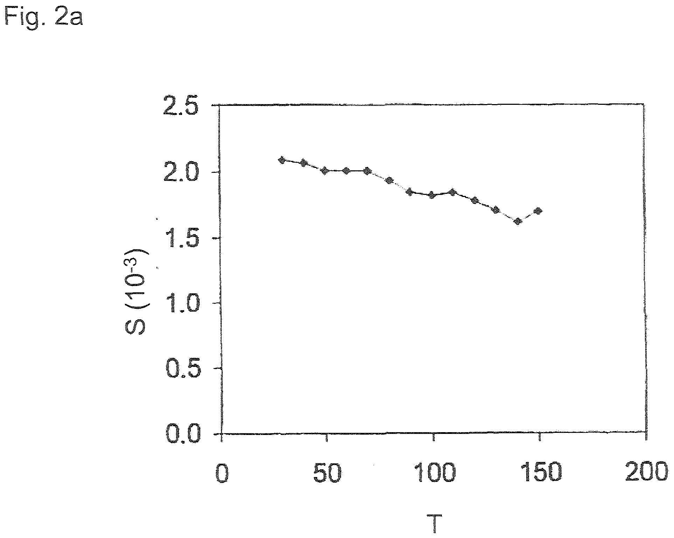

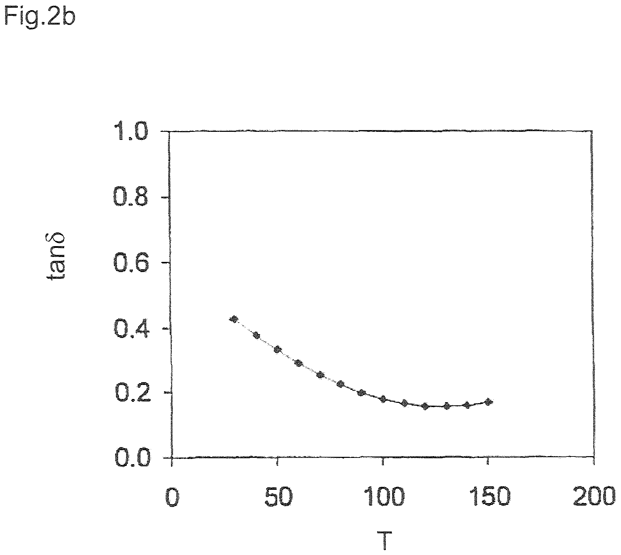

Figur 2 zeigt die grafische Darstellung der Temperaturabhängigkeit der maximalen feldinduzierten Dehnung S und des dielektrischen Verlustfaktors tanδ. In Figur 2a ist die Dehnung S in 10⁻³ gegen die Temperatur T in °C aufgetragen, in Figur 2b ist der dielektrische Verlustfaktor tanδ gegen die Temperatur T in °C aufgetragen. Die feldinduzierte Dehnung S bei 4,7 kV/mm zeigt eine geringe Sensitivität von +/- 10% gegenüber der Temperatur in dem Temperaturbereich zwischen Raumtemperatur und 150°C. Dies ist eine deutliche Verbesserung gegenüber bekannten bleifreien Keramiken.

Gleichzeitig weist der dielektrische Verlustfaktor tanδ kleine Werte auch bei höheren Temperaturen auf (Figur 2b). Die hohe Temperaturstabilität und der niedrige dielektrische Verlustfaktor sind vorteilhafte Eigenschaften für die Anwendung in piezoelektrischen Aktoren.

Im Folgenden werden die Effekte der einzelnen Substituenten in dem keramischen Werkstoff und ihr Einfluss auf die charakteristischen Temperaturen T_{d} (Depolarisationstemperatur) und T_{c} (Curietemperatur) aufgezeigt.

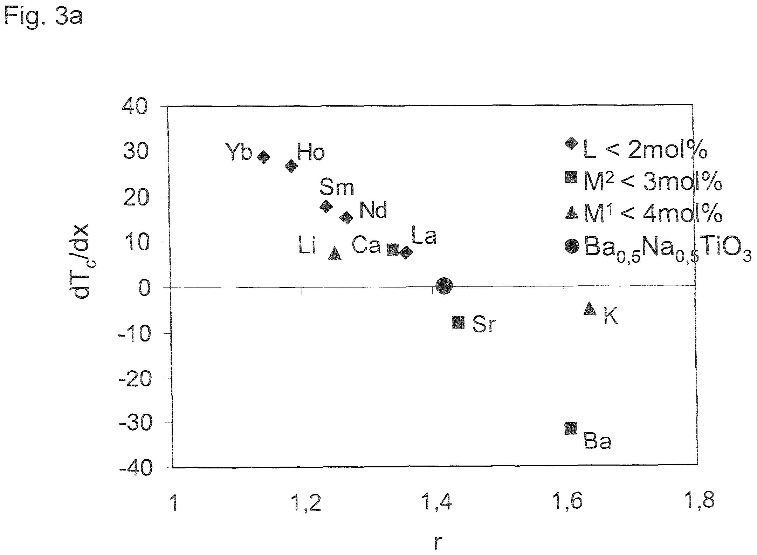

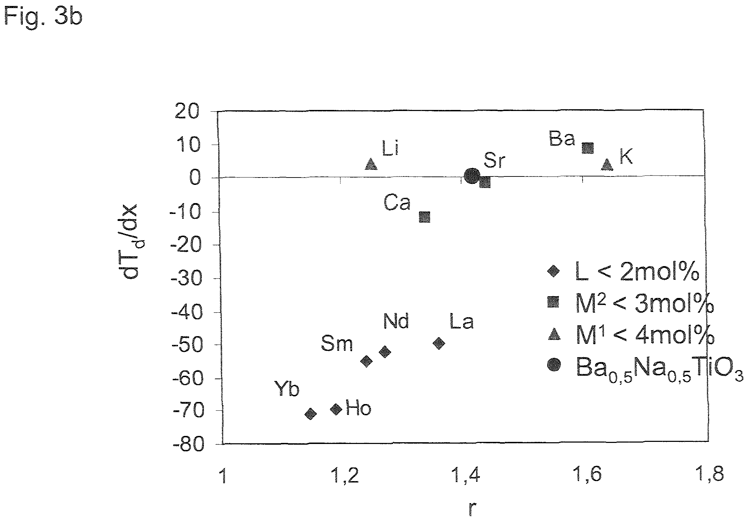

Dazu sind zur Veranschaulichung in Figur 3a die Abhängigkeit der Depolarisationstemperatur von dem Gehalt der Substituenten dT_{d}/dx in °C/mol% gegen den Ionenradius r in Ä aufgetragen und in Figur 3b die Abhängigkeit der Curietemperatur von dem Gehalt der Substituenten dT_{c}/dx in °C/mol% gegen den Ionenradius r in Å aufgetragen. Beide Temperaturen sind normiert auf die Zugabe an Substituenten zu einer Ba_{0,5}Na_{0,5}TiO₃ Keramik. Die verschiedenen Symbole stehen jeweils für die Art der Substituenten M¹ (Alkalimetalle), M² (Erdalkalimetalle) und L (Lanthanoide). Die Prozentangaben in den Legenden der beiden Figuren deuten das Limit der Zugabe an jeweiligen Substituenten in mol% an, bis zu dem der Zusammenhang zwischen der jeweiligen Temperaturveränderung und der zugegebenen Menge an Substituent linear ist. Damit wird der Einfluss eines Substituenten auf die Modifikation der kritischen Temperaturen durch lineares Auftragen der Abhängigkeit der kritischen Temperaturen von dem Gehalt abgeschätzt. Jenseits eines kritischen Wertes des Gehalts können Abweichungen von dem linearen Verhalten, eine Sättigung oder ein Überschreiten der Löslichkeit auftreten.

Die Curietemperatur T_{c} kann stark durch Substituenten auf der A-Position des keramischen Werkstoffs beeinflusst werden. Je kleiner der Ionenradius des Substituenten, desto höher ist der die Curietemperatur (Figur 3a).

Der Fähigkeit eines Substituenten, die Curietemperatur eines keramischen Werkstoffs zu verändern, hängt auch von seiner Löslichkeit in dem Gastgitter ab. Beispielsweise haben die Lanthanoide einen größeren Effekt aber eine geringere Löslichkeit, so dass ihr Einfluss auf die Veränderung der Curietemperatur begrenzt ist. Alkalimetalle lösen sich gut in dem Gastgitter, aber sie können die Curietemperatur nicht mehr verändern, wenn ihr Gehalt 10 mol% übersteigt.

Die Depolarisationstemperatur T_{d} wird generell niedriger bei Zugabe von Substituenten mit kleinen Ionenradien (Figur 3b). Die Zugabe von Ba und Alkalimetalen führt zu unterschiedlichen Effekten: die Zugabe von Ba, Li und/oder K in das Ba_{0,5}Na_{0,5}TiO₃ Gitter stabilisiert die ferroelektrische Phase, solange ihr jeweiliger Gehalt unter einem kritischen Wert liegt. Ein höherer Gehalt dieser Elemente in dem Gitter führt zu einer Erniedrigung der Depolarisationstemperatur mit steigendem Gehalt aufgrund der zunehmenden Zufälligkeit in dem Gitter. Beispielsweise erreicht die Depolarisationstemperatur ein Maximum bei etwa 3 mol% Ba, und sinkt bei einem höheren Gehalt an Ba. Ein Peak der Depolarisationstemperatur tritt weiterhin bei etwa 4 mol% Li und 8 mol% K auf.

Generell kann die Optimierung des Gehalts an Substituenten nach den folgenden Gesichtspunkten erfolgen: Die Curietemperatur sollte über 300°C und die Depolarisationstemperatur unter 0°C liegen um eine schwache Temperaturabhängigkeit der elektromechanischen Eigenschaften zu erlangen. Weiterhin sollte mindestens ein Lanthanoid eingeführt werden um die elektrische und sterische Zufälligkeit auf den A-Positionen in dem Gitter zu erhöhen, um Energieverluste zu vermeiden.

In der folgenden Tabelle sind die Einflüsse der jeweiligen Substituenten aufgezeigt. In der ersten Spalte werden beispielhafte Elemente genannt, die in dem keramischen Werkstoff als Substituenten vorhanden sein können, in der zweiten Spalte ihre Ionenradien r, in der dritten Spalte ihre Wertigkeit, in der vierten Spalte die Gitterplätze, die sie einnehmen, und in der fünften und sechsten Spalte ihr jeweiliger Einfluss auf die Temperaturen T_{c} und T_{d}. Ein nach oben gerichteter Pfeil bedeutet dabei, dass diese Substitution die jeweilige Temperatur erhöht, ein nach unten gerichteter Pfeil bedeutet, dass die Substitution die jeweilige Temperatur erniedrigt, wobei auch Mischformen möglich sind.

| Element | r [Å] | Wertigkeit | Gitterplatz | Einfluss auf T_{c} | Einfluss auf T_{d} |
|---|---|---|---|---|---|
| Na | 1,390 | +1 | - | - | - |
| Bi | 1,450 | +3 | - | - | - |
| Ca | 1,340 | +2 | Bi_{0,5}Na_{0,5} | ↑ | ↓ |
| Sr | 1,440 | +2 | Bi_{0,5}Na_{0,5} | ↓ | ↓ |
| Ba | 1,610 | +2 | Bi_{0,5}Na_{0,5} | ↓ | ↑↓ |
| Yb | 1,144 | +3 | Bi | ↑ | ↓ |
| Ho | 1,187 | +3 | Bi | ↑ | ↓ |
| Nd | 1,270 | +3 | Bi | ↑ | ↓ |
| La | 1,360 | +3 | Bi | ↑ | ↓ |
| Li | 1,252 | +1 | Na | ↑ | ↑↓ |
| K | 1,640 | +1 | Na | ↓ | ↑↓↑ |

Die Erfindung ist nicht auf die oben genannten Ausführungsbeispiele und -formen beschränkt.

### Bezugszeichenliste

- P: Polarisation
- E: elektrisches Feld
- S: Dehnung
- tanδ: dielektrischer Verlustfaktor
- T_{d}: Depolarisationstemperatur
- T_{c}: Curietemeperatur
- r: Ionenradius

## Patentansprüche

1. Keramischer Werkstoff, aufweisend die allgemeine Formel
(BiₓNa_{y}M¹_{z}LᵤM²ᵥV_{w})(Ti₁₋ₛZₛ)O₃,
wobei gilt:
x + y + z + u + v + w = 1,
3x + y + z + 3u + 2v = 2 und
x, y, z, u > 0, v ≥ 0,
M¹ umfasst zumindest ein Element der ersten Hauptgruppe,
M² umfasst zumindest ein Element der zweiten Hauptgruppe,
L umfasst zumindest ein Element der Lanthanoide,
V ist eine Leerstelle und
Z ist ausgewählt aus Zr, Hf und Kombinationen davon, wobei gilt:
0,005 ≤ z ≤ 0,25,
0,005 ≤ v ≤ 0,25,
0,001 ≤ u ≤ 0,02,
0 ≤ w ≤ 0,02,
0 < s ≤ 0,2, wobei M¹ aus einer Gruppe ausgewählt ist, die aus Li und K besteht, und M² aus einer Gruppe ausgewählt ist, die aus 20 Ca, Sr und Ba besteht.

2. Keramischer Werkstoff nach dem vorhergehenden Anspruch, wobei L aus einer Gruppe ausgewählt ist, die aus La, Ce, Pr, Nd, Pm, Sm, Eu, Gd, Tb, Dy, Ho, Er, Tm und Yb besteht.

3. Keramischer Werkstoff nach einem der vorhergehenden Ansprüche, der bleifrei ist.

4. Keramischer Werkstoff nach einem der vorhergehenden Ansprüche, der eine Depolarisationstemperatur < 20°C und eine Curie-Temperatur > 150°C aufweist.

5. Keramischer Werkstoff nach einem der vorhergehenden Ansprüche, der in einem Temperaturbereich von 20°C bis 150°C einen dielektrischen Verlustfaktor von < 0,5 aufweist.

6. Keramischer Werkstoff nach einem der vorhergehenden Ansprüche, der in einem Temperaturbereich von 20°C bis 150°C bei Anlegen eines elektrischen Feldes eine Dehnung, die aus einem Bereich, der 0,1% bis 0,3% umfasst, ausgewählt ist.

7. Keramischer Werkstoff nach einem der vorhergehenden Ansprüche, der in einem Temperaturbereich von 20°C bis 150°C bei Anlegen eines elektrischen Feldes eine Temperaturabhängigkeit von < 30% aufweist.

8. Piezoelektrischer Aktor, der einen keramischen Werkstoff gemäß den Ansprüchen 1 bis 7 enthält.

9. Verfahren zur Herstellung eines keramischen Werkstoffs gemäß den Ansprüchen 1 bis 7 mit den Verfahrensschritten
A) Mischen und Mahlen von pulverförmigen Ausgangsstoffen im stöchiometrischen Verhältnis,
B) Trocknen und Kalzinieren der Mischung,
C) Mahlen der Mischung zu einem keramischen Pulver,
D) Entbindern und Sintern des keramischen Pulvers zu dem keramischen Werkstoff.

10. Verfahren nach dem vorhergehenden Anspruch, wobei die Ausgangsstoffe im Verfahrensschritt A) ausgewählt werden aus Na₂CO₃, TiO₂, Bi₂O₃ und Oxiden und/oder Carbonaten von M¹, M², L und Z.

11. Verfahren nach einem der Ansprüche 9 oder 10, wobei im Verfahrensschritt B) bei 60°C getrocknet und bei einer Temperatur aus dem Bereich 750°C bis 950°C kalziniert wird.

12. Verfahren nach einem der Ansprüche 9 bis 11, wobei im Verfahrensschritt D) bei 450°C entbindert und bei einer Temperatur aus dem Bereich 1000°C bis 1150°C gesintert wird.

## Claims

1. Ceramic material having the general formula
(BiₓNa_{y}M¹_{z}LᵤM²ᵥV_{w})(Tiₗ₋ₛZₛ)O₃,
where:
x + y + z + u + v + w = 1,
3x + y + z + 3u + 2v = 2 and
x, y, z, u > 0, v ≥ 0,
M¹ comprises at least one element of the first main group,
M² comprises at least one element of the second main group,
L comprises at least one element of the lanthanides,
V is a vacancy, and
Z is selected from among Zr, Hf and combinations thereof, wherein:
0.005 ≤ z ≤ 0.25,
0.005 ≤ v ≤ 0.25,
0.001 ≤ u ≤ 0.02,
0 ≤ w ≤ 0.02,
0 < s ≤ 0.2, wherein M¹ is selected from a group consisting of Li and K, and M² is selected from a group consisting of Ca, Sr and Ba.

2. Ceramic material according to the preceding claim, wherein L is selected from a group consisting of La, Ce, Pr, Nd, Pm, Sm, Eu, Gd, Tb, Dy, Ho, Er, Tm and Yb.

3. Ceramic material according to any of the preceding claims which is lead-free.

4. Ceramic material according to any of the preceding claims which has a depolarization temperature of < 20°C and a Curie temperature of > 150°C.

5. Ceramic material according to any of the preceding claims which has a dielectric loss factor of < 0.5 in a temperature range from 20°C to 150°C.

6. Ceramic material according to any of the preceding claims which has an expansion in a range from 0.1% to 0.3% on application of an electric field in a temperature range from 20°C to 150°C.

7. Ceramic material according to any of the preceding claims which has a temperature dependence of < 30% on application of an electric field in the temperature range from 20°C to 150°C.

8. Piezoelectric actuator containing a ceramic material according to any of Claims 1 to 7.

9. Process for producing a ceramic material according to any of Claims 1 to 7, which comprises the process steps
A) mixing and milling of pulverulent starting materials in the stoichiometric ratio,
B) drying and calcination of the mixture,
C) milling of the mixture to give a ceramic powder
D) removal of binder from and sintering of the ceramic powder to give the ceramic material.

10. Process according to the preceding claim, wherein the starting materials in process step A) are selected from among Na₂CO₃, TiO₂, Bi₂O₃ and oxides and/or carbonates of M¹, M², L and Z.

11. Process according to either of Claim 9 or 10, wherein, in process step B), drying is carried out at 60°C and calcination is carried out at a temperature in the range from 750°C to 950°C.

12. Process according to any of Claims 9 to 11, wherein, in process step D), binder removal is carried out at 450°C and sintering is carried out at a temperature in the range from 1000°C to 1150°C.

## Revendications

1. Matériau céramique, présentant la formule générale
(BiₓNa_{y}M¹_{z}LᵤM²ᵥV_{w})(Ti₁₋ₛZₛ)O₃,
dans laquelle :
x + y + z + u + v + w = 1,
3x + y + z + 3u + 2v = 2 et
x, y, z, u > 0, v ≥ 0,
M¹ comprend au moins un élément du premier groupe principal,
M² comprend au moins un élément du deuxième groupe principal,
L comprend au moins un élément des lanthanides,
V représente un espace vide et
Z est choisi parmi Zr, Hf et des combinaisons de ceux-ci, où :
0,005 ≤ z ≤ 0,25,
0,005 ≤ v ≤ 0,25,
0,001 ≤ u ≤ 0,02,
0 ≤ w ≤ 0,02,
0 < s ≤ 0,2,
M¹ étant choisi dans un groupe constitué par Li et K et M² étant choisi dans un groupe constitué par Ca, Sr et Ba.

2. Matériau céramique selon la revendication précédente, L étant choisi dans un groupe constitué par La, Ce, Pr, Nd, Pm, Sm, Eu, Gd, Tb, Dy, Ho, Er, Tm et Yb.

3. Matériau céramique selon l'une quelconque des revendications précédentes, qui est exempt de plomb.

4. Matériau céramique selon l'une quelconque des revendications précédentes, qui présente une température de dépolarisation < 20°C et une température de Curie > 150°C.

5. Matériau céramique selon l'une quelconque des revendications précédentes, qui présente, dans une gamme de température de 20°C à 150°C, un facteur de perte diélectrique < 0,5.

6. Matériau céramique selon l'une quelconque des revendications précédentes, qui présente, dans une gamme de température de 20°C à 150°C, lors de l'application d'un champ électrique, une dilatation qui est choisie dans une gamme qui comprend 0,1% à 0,3%.

7. Matériau céramique selon l'une quelconque des revendications précédentes, qui présente, dans une gamme de température de 20°C à 150°C, lors de l'application d'un champ électrique, une dépendance de la température < 30%.

8. Actuateur piézoélectrique, qui contient un matériau céramique selon les revendications 1 à 7.

9. Procédé pour la préparation d'un matériau céramique selon les revendications 1 à 7, présentant les étapes de procédé :
A) mélange et broyage de substances de départ sous forme de poudre dans un rapport stoechiométrique,
B) séchage et calcination du mélange,
C) broyage du mélange en une poudre céramique,
D) élimination du liant et frittage de la poudre céramique en matériau céramique.

10. Procédé selon la revendication précédente, les substances de départ dans l'étape de procédé A) étant choisies parmi Na₂CO₃, TiO₂, Bi₂O₃ et les oxydes et/ou les carbonates de M¹, de M², de L et de Z.

11. Procédé selon l'une quelconque des revendications 9 ou 10, dans lequel, dans l'étape de procédé B), le séchage est effectué à 60°C et la calcination est effectuée à une température dans la gamme de 750°C à 950°C.

12. Procédé selon l'une quelconque des revendications 9 à 11, dans lequel, dans l'étape de procédé D), l'élimination du liant est effectuée à 450°C et le frittage est effectué à une température dans la gamme de 1000°C à 1150°C.
